# EUROPEAN PATENT APPLICATION

(11) **EP 4 580 046 A1**
(43) Date of publication of application: **02.07.2025**
(21) Application number: 24182246.9
(22) Date of filing: 14.06.2024
(51) Int. Cl.: H02S 50/10, H02H 7/20, H02H 1/00, H02H 7/12, H02M 1/32, G01R 31/52, H02H 7/18

(54) **METHOD FOR DETECTING ARCING, INVERTER AND PHOTOVOLTAIC SYSTEM**

(30) Priority: 26.12.2023 CN 202311824115
(71) Applicant: Sungrow Power Supply Co., Ltd., Hefei, Anhui 230088 (CN)
(72) Inventor: ZHOU, Yinyin, Hefei, 230088 (CN); CHEN, Tiantian, Hefei, 230088 (CN); YANG, Yongchang, Hefei, 230088 (CN); WANG, Wei, Hefei, 230088 (CN); HUANG, Zhifeng, Hefei, 230088 (CN)
(74) Representative: Epping - Hermann - Fischer

(57) **Abstract**

A method for detecting arcing, an inverter (100) and a photovoltaic (31) system are provided. The inverter (100) includes an inverter circuit (10) and DC/DC conversion circuits (20). The method includes: stopping outputting a control signal to a first DC/DC conversion circuit that is currently being suspected of having an electric arc and operating other DC/DC conversion circuits connected to the inverter circuit normally (S3015); decreasing a voltage at a power supply side of the first DC/DC conversion circuit immediately after a first preset period of time elapsed (S302); and determining that no arc fault occurs, and restoring the voltage at the power supply side of the first DC/DC conversion circuit to a first voltage that the first DC/DC conversion circuit receives before the stopping outputting the control signal, if a current at the power supply side is greater than or equal to a first preset current during the decreasing the voltage (S303).

## Description

### FIELD

The present disclosure relates to the technical field of photovoltaics, and in particular to a method for detecting arcing, an inverter and a photovoltaic system.

### BACKGROUND

Currently, when a suspected electric arc is detected, all DC/DC conversion circuits are turned off, and direct-current current flowing through an inverter is decreased to 0A. When determined that the electric arc has been completely extinguished, the inverter is controlled to rapidly start to output voltage equal to that supplied by the inverter before being turned off. A photovoltaic string where the electric arc actually occurs is disconnected from the inverter when the current is decreased to 0A, and therefore fails to supply current even if the inverter has been rapidly started.

However, during a process from turning off the inverter to rapidly starting the inverter to supply the same voltage, there may be a photovoltaic string that fails to supply current due to factors such as changes in sunlight and especially changes in the IV curve resulted from interference in communication by adaptive optimizers and rapid shutdown devices at the direct-current side. This failure to supply current may be misdiagnosed as an arc fault.

### SUMMARY

In view of this, a method for detecting arcing, an inverter and a photovoltaic system are provided according to embodiments of the present disclosure, to avoid misdiagnoses of an arc fault.

In a first aspect, the method for detecting arcing is provided according to an embodiment of the present disclosure, and is applied to an inverter. The inverter includes an inverter circuit and at least one DC/DC conversion circuit connected to a direct-current side of the inverter circuit. The method includes: stopping outputting a control signal to a first DC/DC conversion circuit that is currently being suspected of having an electric arc, and operating other DC/DC conversion circuits connected to the inverter circuit normally; decreasing a voltage at a power supply side of the first DC/DC conversion circuit immediately after a first preset period of time elapsed; and determining that no arc fault occurs, and restoring the voltage at the power supply side of the first DC/DC conversion circuit to a first voltage that the first DC/DC conversion circuit receives before the stopping outputting the control signal, if a current at the power supply side is greater than or equal to a first preset current during the decreasing the voltage.

In an embodiment, the decreasing the voltage at the power supply side of the first DC/DC conversion circuit immediately after the first preset period of time elapsed includes: decreasing the voltage at the power supply side of the first DC/DC conversion circuit to a target voltage immediately when the first preset period of time expires; and proceeding to decrease the voltage at the power supply side of the first DC/DC conversion circuit, if the current at the power supply side is less than the first preset current throughout the decreasing the voltage to the target voltage.

In an embodiment, the target voltage is equal to the first voltage. The target voltage is variable and may be set to a value that is insufficient to cause arcing, for example, around 60V

In an embodiment, the method further includes determining that an arc fault occurs, if the current at the power supply side is less than the first preset current throughout the decreasing the voltage.

In an embodiment, the current at the power supply side being less than the first preset current throughout the decreasing the voltage is determined by: acquiring the current at the power supply side at the beginning of the decreasing the voltage; decreasing the voltage at the power supply side of the first DC/DC conversion circuit by a first parameter and measuring the current at the power supply side subsequently, if the acquired current at the power supply side is less than the first preset current; and proceeding to decrease the voltage at the power supply side of the first DC/DC conversion circuit by the first parameter and measure the current at the power supply side subsequently until the voltage at the power supply side of the first DC/DC conversion circuit is decreased to a voltage when the decreasing the voltage ends, if the previously measured current at the power supply side is less that the first preset current, where the finally measured current at the power supply side is less than the first preset current.

In an embodiment, the current at the power supply side being less than the first preset current throughout the decreasing the voltage is determined by: acquiring the current at the power supply side at the beginning of the decreasing the voltage; and decreasing the voltage at the power supply side of the first DC/DC conversion circuit to a voltage when the decreasing the voltage ends and measuring the current at the power supply side subsequently, if the acquired current at the power supply side is less than the first preset current, where the measured current at the power supply side is less than the first preset current.

In an embodiment, the current at the power supply side being greater than or equal to the first preset current is determined by: determining that a minimum among absolute values of respective currents of all direct-current power supplies connected to the power supply side of the first DC/DC conversion circuit is greater than or equal to the first preset current; or determining that absolute values of respective currents of all direct-current power supplies connected to the power supply side of the first DC/DC conversion circuit each are greater than or equal to the first preset current.

In an embodiment, the method further includes: generating an alarm message and outputting the alarm message, when it is determined that an arc fault occurs.

In a second aspect, an inverter is further provided according to the present disclosure. The inverter includes a controller, an inverter circuit and at least one DC/DC conversion circuit. A power supply side of the DC/DC conversion circuit serves as an interface at a direct-current side of the inverter, for connecting at least one direct-current power supply. A bus side of the DC/DC conversion circuit is connected to a direct-current side of the inverter circuit through a direct-current bus. An alternating-current side of the inverter circuit serves as an alternating-current side of the inverter for connecting at least one of a power grid and an alternating-current load. The controller is configured to control the inverter circuit and the DC/DC conversion circuit to perform the method in the first aspect.

In an embodiment, the direct-current power supply is a photovoltaic string or a battery cluster.

In a third aspect, a photovoltaic system is further provided according to the present disclosure. The photovoltaic system includes a photovoltaic string and the inverter described in the second aspect. The photovoltaic string is connected to an interface at the direct-current side of the inverter. The alternating-current side of the inverter is for connecting at least one of a power grid and an alternating-current load.

The method for detecting arcing, the inverter and the photovoltaic system are provided according to the embodiments of the present disclosure. The inverter includes the inverter circuit and at least one DC/DC conversion circuit connected to the direct-current side of the inverter circuit. The method includes: stopping outputting a control signal to a first DC/DC conversion circuit that is currently being suspected of having an electric arc, and operating other DC/DC conversion circuits connected to the inverter circuit normally; decreasing a voltage at a power supply side of the first DC/DC conversion circuit immediately after a first preset period of time elapsed; and determining that no arc fault occurs, and restoring the voltage at the power supply side of the first DC/DC conversion circuit to a first voltage that the first DC/DC conversion circuit receives before the stopping outputting the control signal, if a current at the power supply side is greater than or equal to a first preset current during the decreasing the voltage. In the present disclosure, the voltage at the power supply side of the first DC/DC conversion circuit is decreased, and the detection of an outputted current greater than the first preset current at the power supply side of the first DC/DC conversion circuit is performed throughout. It is determined that there is no arc fault if such current has been detected, thereby avoiding misdiagnoses of an arc fault and improving accuracy of arc fault detection.

### BRIEF DESCRIPTION OF THE DRAWINGS

In order to more clearly illustrate technical solutions in embodiments of the present disclosure or in the conventional technology, the drawings to be used in the description of the embodiments or the conventional technology are briefly described below. It is apparent that the drawings in the following description show only some embodiments of the present disclosure, and other drawings may be obtained by those skilled in the art from the drawings without any creative work.
Figure 1 is a schematic structural diagram illustrating an inverter according to an embodiment of the present disclosure;
Figure 2 is a schematic structural diagram illustrating the inverter according to another embodiment of the present disclosure;
Figure 3 is a schematic flow chart illustrating a method for detecting arcing according to an embodiment of the present disclosure; and
Figure 4 is a schematic flow chart illustrating the method for detecting arcing according to an embodiment of the present disclosure.

### DETAILED DESCRIPTION

Technical solutions of embodiments of the present disclosure are clearly and completely described hereinafter in conjunction with the drawings of the embodiments of the present disclosure. Apparently, the embodiments described below are only some rather than all embodiments of the present disclosure. Based on the embodiments disclosed herein, all other embodiments obtained by those skilled in the art without any creative work fall within the protection scope of the present disclosure.

Terms including "first", "second", "third", "fourth" and the like (if any) in the specification and claims of the present disclosure and the above drawings are used to distinguish similar objects, and are not necessarily used to describe a specific order or sequence. It should be understood that the terms used in this way may be exchanged under an appropriate condition, such that the embodiments of the present disclosure described herein can be implemented in an order different from the order shown or described herein. Moreover, the terms such as "comprise", "have" or any other variants thereof are intended to be non-exclusive. For example, a process, method, system, product or apparatus including a series of steps or elements includes not only the expressly listed steps or elements but also other steps or elements that are not enumerated or are inherent in the process, method, system, product or apparatus.

It should be noted that, the terms "first", "second" and the like are used only for description, and should not be construed as indicating or implying relative importance or implying the number of the indicated technical features. Therefore, features defined with "first" or "second" may include at least one of the features explicitly or implicitly. In addition, the technical solutions between the various embodiments can be combined with each other, and the combined technical solution is to be implemented by those skilled in the art. When a combination of the technical solutions is contradictory or cannot be implemented, it should be considered that such the combination of the technical solutions does not exist, and is not within the protection scope of the present disclosure.

In the present disclosure, the terms "include", "comprise" or any other variants thereof are intended to be non-exclusive. Therefore, a process, method, article or device including a series of elements includes not only the elements but also other elements that are not enumerated, or further includes elements inherent in the process, method, article or device. Unless expressively limited otherwise, the statement "comprising/including one ..." does not exclude existence of another identical element in such process, method, article or device.

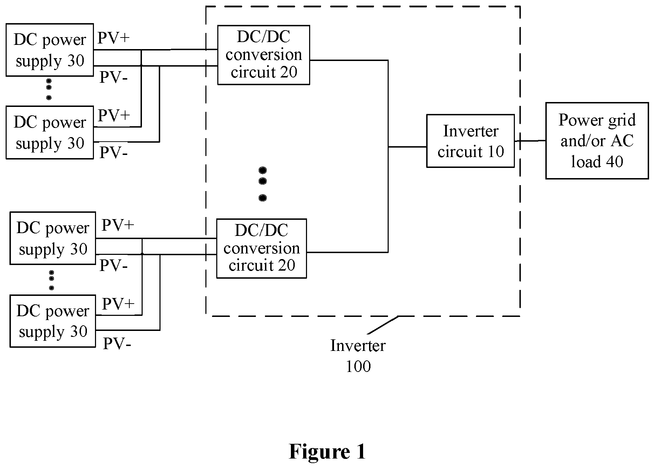

Reference is made to Figure 1, which is a schematic structural diagram illustrating an inverter according to an embodiment of the present disclosure.

An inverter 100 includes a controller (not shown in the drawings), an inverter circuit 10, and at least one DC/DC conversion circuit 20. A power supply side of the one DC/DC conversion circuit 20 serves as an interface at a direct-current side of the inverter, for connecting at least one direct-current power supply 30. A bus side of the at least one DC/DC conversion circuit 20 is connected to a direct-current side of the inverter circuit 10 through a direct-current bus. An alternating-current side of the inverter circuit 10 serves as an alternating-current side of the inverter, for connecting at least one of a power grid and an alternating-current load 40.

It should be noted that a side of the DC/DC conversion circuit 20 that is connected to the direct-current power supply 30 is referred to as the power supply side, and a side of the DC/DC conversion circuit 20 that is connected to the inverter circuit 10 is referred to as the bus side.

The inverter circuit 10 and the DC/DC conversion circuit 20 are both controlled by the controller.

It should be noted that the direct-current side of the inverter 100 is provided with multiple interfaces, and each of the multiple interfaces is a side of one DC/DC conversion circuit 20.

In an embodiment, the direct-current power supply 30 is a photovoltaic string or a battery cluster.

In an embodiment of the present disclosure, the direct-current power supply 30 is the battery cluster, and the inverter 100 is bidirectional, that is, can function in charging and discharging modes. For example, in the discharging mode, the DC/DC conversion circuit 20 boots voltage from the battery cluster and then supplies the increased voltage to the inverter circuit 10. In the charging mode, the DC/DC conversion circuit 20 steps down the voltage from the battery cluster, and then supplies the decreased voltage to the inverter circuit 20. Based on this, the DC/DC conversion circuit 20 is not limited to a boost circuit BOOST.

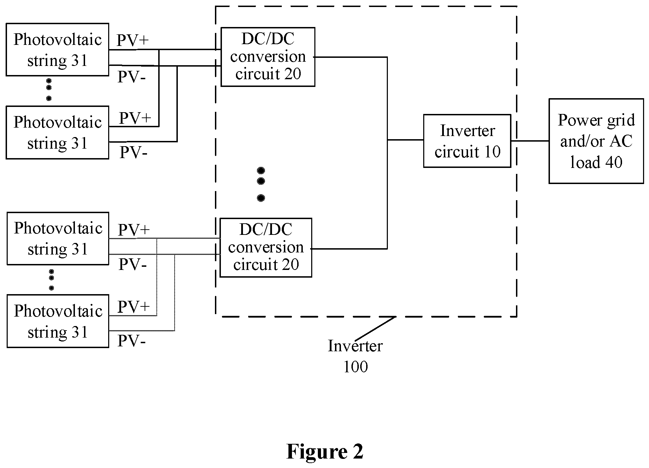

In an embodiment, the direct-current power supply 30 is the photovoltaic string 31, and the inverter 100 is arranged in a photovoltaic system. Figure 2 is a schematic structural diagram illustrating the inverter. The photovoltaic system includes the photovoltaic strings 31 and the inverter 100 as shown in Figure 2.

A corresponding interface at the power supply side of the inverter 100 is connected to at least one photovoltaic string 31. The alternating-current side of the inverter 31 is connected to the power grid and/or the alternating-current load 40.

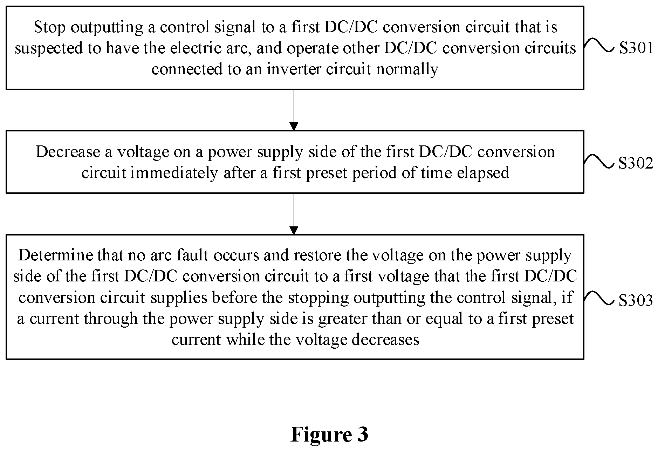

Based on the structure of the inverter described above, a method for detecting arcing is implemented by the controller in the inverter. Reference is made to Figure 3, which is a schematic flow chart illustrating the method for detecting arcing. The method for detecting arcing includes the following steps S301 to S303.

In step S301, outputting a control signal to a first DC/DC conversion circuit that is currently being suspected of having an electric arc ends at occurrence of a suspected electric arc is detected, and other DC/DC conversion circuits connected to the inverter circuit each operate normally.

The suspected electric arc is a false electric arc caused by a voltage disturbance or other factors, or a real electric arc. There may be one or more first DC/DC conversion circuits that are currently being suspected of having an electric arc. The control signal may be stopped to be outputted to part or all of the first DC/DC conversion circuits.

The false electric arc may be detected when a photovoltaic string fails to supply current due to factors such as a change in sunlight conditions, and especially changes in the IV curve resulted from interference in communication by adaptive optimizers and rapid shutdown devices at the direct-current side.

The real electric arc occurs when a photovoltaic string fails to supply current even if the inverter has been rapidly started and resumed normally operating.

The electric arc is one representation of the arc fault.

The outputting a control signal to a first DC/DC conversion circuit that is currently being suspected of having an electric arc ends, that is, the first DC/DC conversion circuit is turned off, and switching transistors in the first DC/DC conversion circuit are off.

The controller detects whether a suspected electric arc occurs in the inverter. A DC/DC conversion circuit that is currently being suspected of having an electric arc is determined as the first DC/DC conversion circuit.

For example, for each DC/DC conversion circuits in the inverter, the controller measures current through a circuit connecting the DC/DC conversion circuit to a corresponding photovoltaic string. A DC/DC conversion circuit connected to a circuit where a sudden change in current is being detected is determined as the first DC/DC conversion circuit.

In the present disclosure, the number of the first DC/DC conversion circuit may be one or more.

The other DC/DC conversion circuits connected to the inverter circuit each operate normally, that is, switching transistors in the DC/DC conversion circuit are on. The other DC/DC conversion circuits each output constant power.

In an embodiment, a first voltage *Vₚᵣₑ* and a first current *Iₚᵣₑ* of the first DC/DC conversion circuit that is currently being suspected of having an electric arc are recorded before ending the outputting a control signal to the first DC/DC conversion circuit.

In step S302, a voltage at the power supply side of the first DC/DC conversion circuit is decreased immediately after a first preset period of time elapsed.

The first preset period of time is determined by technicians based on experiments or experience. For example, the first preset period of time is set to 200ms.

The decreasing the voltage at the power supply side of the first DC/DC conversion circuit includes: resuming outputting the control signal, adjusting a duty cycle of the control signal, and decreasing the voltage at the power supply side of the first DC/DC conversion circuit.

In step S303, if a current at the power supply side is greater than or equal to a first preset current during the decreasing the voltage, it is determined that no arc fault occurs and the voltage at the power supply side of the first DC/DC conversion circuit is restored to a first voltage that the first DC/DC conversion circuit supplies before ending the outputting the control signal.

The above first preset current is set based on the first current.

For example, the first preset current is set to Iₛₑₜ=K×I*ₚᵣₑ*, where K ranges from 0.1 to 1.

It can be seen form steps S301 to S304 that in the present disclosure, the voltage at the power supply side of the first DC/DC conversion circuit is decreased. During the decreasing the voltage. It is determined that there is no arc fault if an outputted current greater than the first preset current at the power supply side of the first DC/DC conversion circuit is detected. Therefore, misdiagnoses of an arc fault can be avoided. In addition, only the first DC/DC conversion circuit that is currently being suspected of having an electric arc is involved, which is grid-friendly and results in minimum fluctuation in power, and minimally affects power generation.

In the embodiment of the present disclosure, the decreasing the voltage at the power supply side of the first DC/DC conversion circuit immediately after the first preset period of time elapsed in step S302 of Figure 1 may be implemented in the following manners, which are introduced individually below. It should be noted that the implementations in the following introduction are only for illustration and do not represent all implementations of the present disclosure.

In an embodiment, the voltage is directly decreased to a preset voltage. The preset voltage is extremely low (for example, 0V).

In another embodiment, the voltage is first decreased to a target voltage, and thence to the preset voltage. The target voltage is set based on experiences. If the voltage is first decreased to the target voltage and the current at the power supply side of the first DC/DC conversion circuit is less than the first preset current throughout, the decreasing the voltage proceeds until the voltage is decreased to the extremely low voltage (for example, 0V). If the voltage is first decreased to the target voltage and the outputted current once is greater than the first preset current, the voltage is unnecessarily decreased to the preset voltage, and it is determined that there is no arc fault.

The decreasing the voltage in step S302 includes the following steps S3021 to S3023.

In step S3021, the voltage at the power supply side of the first DC/DC conversion circuit decreased to the target voltage immediately when the first preset period of time expires.

In an embodiment, the target voltage is equal to the first voltage. In other embodiments, the target voltage is set based on experiences or experiments.

In step S3022, if the current at the power supply side is always less than the first preset current throughout the decreasing the voltage to the target voltage, the voltage at the power supply side of the first DC/DC conversion circuit is then decreased and step S3023 is performed. If the current at the power supply side is once greater than or equal to the first preset current during the decreasing the voltage to the target voltage, it is confirmed that no arc fault occurs and the voltage at the power supply side of the first DC/DC conversion circuit is restored to the first voltage.

The decreasing the voltage to the target voltage indicates restoring the voltage to the first voltage, that is, restoring the originally outputted power. If the current at the power supply side of the first DC/DC conversion circuit is never greater than or equal to the first preset current, that is, no current is outputted, it is determined that an arc fault likely occurs, and thence the voltage decreased confirm the occurrence of the arc fault, thereby improving the accuracy of arc fault detection.

In step S3023, if the current at the power supply side is less than the first preset current throughout the decreasing the voltage from the target voltage, it is confirmed that the arc fault occurs. If the current at the power supply side is once greater than or equal to the first preset current during the decreasing the voltage from the target voltage, it is confirmed that no arc fault occurs and the voltage at the power supply side of the first DC/DC conversion circuit is restored to the first voltage.

According to the present disclosure, the voltage at the power supply side of the first DC/DC conversion circuit is first decreased to the target voltage, and the current at the power supply side of the first DC/DC conversion circuit is compared with the first preset current to determine whether there is current outputted. If the current at the power supply side of the first DC/DC conversion circuit is always less than the first preset current, that is, no current is outputted, the voltage is thence decreased from the target voltage. If the current at the power supply side of the first DC/DC conversion circuit is never greater than or equal to the first preset current, that is, no current is outputted, it is confirmed that the arc fault actually occurs. If the current at the power supply side is once greater than or equal to the first preset current during the decreasing the voltage, that is, there is current outputted, it is confirmed that no arc fault occurs, thereby avoiding misdiagnoses of an arc fault and improving accuracy of arc fault detection. In addition, only the first DC/DC conversion circuit that is currently being suspected of having an electric arc is involved, which is grid-friendly and results in minimum fluctuation in power, and minimally affects power generation.

In an embodiment, the current at the power supply side is always less than the first preset current throughout the decreasing the voltage at the power supply side of the first DC/DC conversion circuit as shown in Figure 1, which is detailed as follows. If the current at the power supply side of the first DC/DC conversion circuit is less than the first preset current throughout the decreasing the voltage, it is confirmed that there is an arc fault.

The voltage is decreased in several ways. For example, the voltage is progressively decreased or is directly decreased to a desired voltage. These ways are detailed individually below. It should be noted that the implementations in the following introduction are only for illustration and do not represent all implementations of the present disclosure.

In an embodiment, the voltage is progressively decreased through the following steps A1 to A7.

In step A1, the current at the power supply side of the first DC/DC conversion circuit is acquired at the beginning of the decreasing the voltage.

In step A2, it is determined whether the acquired current at the power supply side of the first DC/DC conversion circuit is less than the first preset current.

In step A3, if the acquired current at the power supply side of the first DC/DC conversion circuit is less than the first preset current, the voltage at the power supply side of the first DC/DC conversion circuit is decreased by a first parameter, and subsequently the current at the power supply side of the first DC/DC conversion circuit is measured and the method proceeds to A5.

In step A4, if the current at the power supply side is greater than or equal to the first preset current, it is confirmed that there is no arc fault, the voltage at the power supply side of the first DC/DC conversion circuit is restored to the first voltage, and the method ends.

In step A5, it is determined whether the measured current at the power supply side of the first DC/DC conversion circuit is less than the first preset current.

In step A6, if the previously measured current at the power supply side is less that the first preset current, the method returns to A3 to A6 until the voltage at the power supply side of the first DC/DC conversion circuit is decreased to a voltage when the decreasing the voltage ends. The finally measured current at the power supply side is less than the first preset current.

In step A7, if the previously measured current at the power supply side is less that the first preset current, the voltage at the power supply side of the first DC/DC conversion circuit is decreased thence. That is, if the voltage has been decreased to the target voltage, then the voltage is decreased from the target voltage. If the voltage has been decreased to be less than or equal to the preset voltage (that is an extremely low voltage less than the target voltage), it is confirmed that an arc fault occurs. If the previously measured current at the power supply side is greater than or equal to the first preset current, it is confirmed that there is no arc fault, the voltage at the power supply side of the first DC/DC conversion circuit is restored to the first voltage, and the method ends.

In an embodiment, the voltage is progressively decreased at equal intervals, that is, the voltage is decreased by the first parameter that is constant. For example, the voltage is decreased by 5V each time. In another embodiment, the voltage is progressively decreased at equally descending intervals, that is, first parameters by which the voltage is progressively decreased form an arithmetic sequence. For example, the voltage is decreased by 5V for the first time, by 4V for the second time, and by 3V for the third time. In other embodiments, the voltage is progressively decreased at other intervals, which is not limited herein.

It can be seen from the above steps A1 to A4 that the voltage at the power supply side of the first DC/DC conversion circuit is progressively decreased. If the current at the power supply side is once greater than or equal to the first preset current during the decreasing the voltage, it is confirmed that no arc fault occurs, and then the method ends. Otherwise, the method proceeds.

In another embodiment, the voltage is decreased through the following steps B1 to B3.

In step B1, the current at the power supply side of the first DC/DC conversion circuit is acquired at the beginning of the decreasing the voltage.

In step B2, if the acquired current at the power supply side is less than the first preset current, the voltage at the power supply side of the first DC/DC conversion circuit is decreased to a voltage when the decreasing the voltage ends, and the current at the power supply side is measured subsequently.

In step B3, if the previously measured current at the power supply side is greater than or equal to the first preset current, it is confirmed that there is no arc fault, the voltage at the power supply side of the first DC/DC conversion circuit is restored to the first voltage, and the method ends.

If the previously measured current at the power supply side is greater than or equal to the first preset current, the method proceeds. That is, if the voltage has been decreased to the target voltage, then the voltage is decreased from the target voltage. If the voltage has been decreased to the preset voltage, it is confirmed that an arc fault occurs.

It can be seen from the above steps B1 to B3 that the current at the power supply side of the first DC/DC conversion circuit is compared with the first preset current at the beginning of the decreasing the voltage and at the end of the decreasing the voltage. If the current at the power supply side is less than the first preset current in both comparisons, the method proceeds. If the current at the power supply side is greater than or equal to the first preset current in any of the comparisons, it is determined that there is no arc fault, the voltage is restored and the method ends. In this way, the number of comparisons is reduced while the efficiency of arc fault detection is improved. As long as the current at the power supply side is greater than or equal to the first preset current once, it is confirmed that there is no arc fault.

In the above embodiments, the current at the power supply side of the first DC/DC conversion circuit is the current of all direct-current power supplies connected to the power supply side of the first DC/DC conversion circuit.

Therefore, the determination of the current at the power supply side of the first DC/DC conversion circuit greater than or equal to the first preset current described above has the follows manners.

In an embodiment, it is determined that a minimum among absolute values of respective currents of all the direct-current power supplies connected to the power supply side of the first DC/DC conversion circuit is greater than or equal to the first preset current. The minimum among absolute values of respective currents of all the direct-current power supplies connected to the power supply side of the first DC/DC conversion circuit is determined. If the minimum is greater than or equal to the first preset current, it is determined that the current at the power supply side of the first DC/DC conversion circuit is greater than or equal to the first preset current.

In another embodiment, it is determined that absolute values of respective currents of all the direct-current power supplies connected to the power supply side of the first DC/DC conversion circuit each are greater than or equal to the first preset current. The absolute values of currents of all the direct-current power supplies connected to the power supply side of the first DC/DC conversion circuit each are compared with the first preset current. If the absolute values of respective currents of all the direct-current power supplies connected to the power supply side of the first DC/DC conversion circuit each are greater than or equal to the first preset current, it is determined that the current at the power supply side of the first DC/DC conversion circuit is greater than or equal to the first preset current.

In addition, the determination of the current at the power supply side of the first DC/DC conversion circuit less than the first preset current described above has has the follows manners.

In an embodiment, it is determined that a maximum among absolute values of respective currents of all the direct-current power supplies connected to the power supply side of the first DC/DC conversion circuit is less than the first preset current. The maximum among absolute values of respective currents of all the direct-current power supplies connected to the power supply side of the first DC/DC conversion circuit is determined. If the maximum is less than the first preset current, it is determined that the current at the power supply side of the first DC/DC conversion circuit is less than the first preset current.

In another embodiment, absolute values of respective currents of all the direct-current power supplies connected to the power supply side of the first DC/DC conversion circuit each are less than the first preset current. The absolute values of respective currents of all the direct-current power supplies connected to the power supply side of the first DC/DC conversion circuit each are compared with the first preset current. If the absolute values of respective currents of all the direct-current power supplies connected to the power supply side of the first DC/DC conversion circuit are less than the first preset current, it is determined that the current at the power supply side of the first DC/DC conversion circuit is less than the first preset current.

In some embodiments, when it is confirmed that an arc fault occurs, an alarm message is generated and is outputted.

For example, the alarm message is outputted by an indicator, or is indicated by displaying an abnormal position on a display screen, or is displayed in other manners, which are not limited herein.

The method for detecting arcing according to the embodiments of the present disclosure is described above. Hereinafter, the method for detecting arcing is illustrated in conjunction with a specific application scenario.

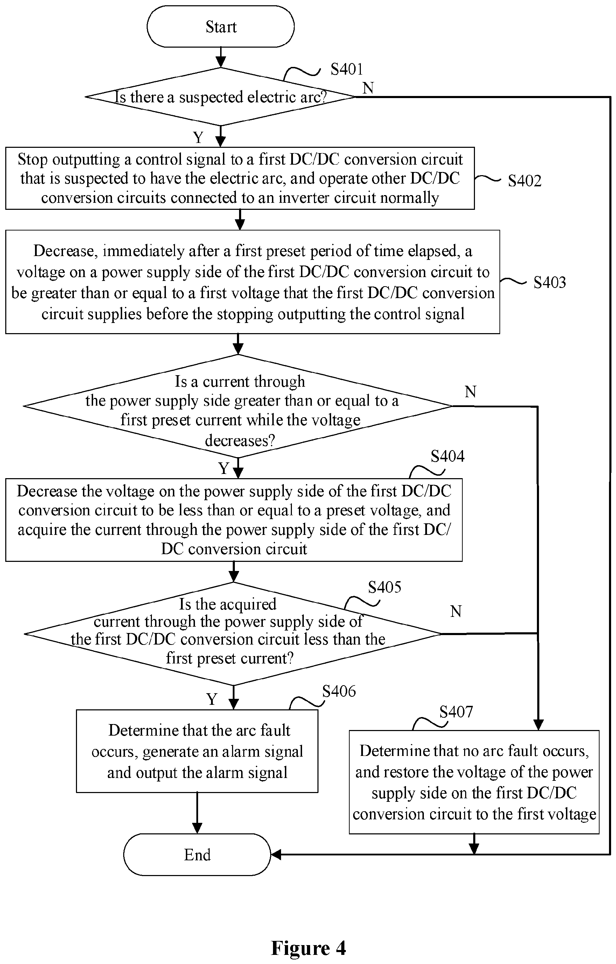

Reference is made to Figure 4, which is a schematic flow chart illustrating the method for detecting arcing. The method for detecting arcing is illustrated through the following steps S401 to S407.

In step S401, it is detected whether there is a suspected electric arc.

In step S402, outputting a control signal to a first DC/DC conversion circuit that is currently being suspected of having an electric arc ends at the occurrence of the suspected electric arc is detected, and other DC/DC conversion circuits connected to the inverter circuit each operate normally.

A first voltage *Vₚᵣₑ* and a first current *Iₚᵣₑ* of the first DC/DC conversion circuit that is currently being suspected of having an electric arc are recorded before ending the outputting a control signal to the first DC/DC conversion circuit.

In step S403, a voltage at the power supply side of the first DC/DC conversion circuit is decreased to the first voltage *Vₚᵣₑ* immediately after a first preset period of time elapsed. It is determined during the decreasing the voltage whether a current at the power supply side is greater than or equal to a first preset current. If the current at the power supply side of the first DC/DC conversion circuit is always less than the first preset current throughout, the method proceeds to step S404. If the current at the power supply side of the first DC/DC conversion circuit is greater than or equal to the first preset current, the method proceeds to step S407.

For example, the first preset current is set to Iₛₑₜ=K×I*ₚᵣₑ*, where K ranges from 0.1 to 1.

In step S404, the voltage at the power supply side of the first DC/DC conversion circuit is decreased to be less than or equal to a preset voltage, and the current at the power supply side of the first DC/DC conversion circuit is measured.

The preset voltage is less than the first voltage *Vₚᵣₑ,* and is extremely low, for example, 0V

In step S405, it is determined whether the measured current at the power supply side of the first DC/DC conversion circuit is less than the first preset current. If the measured current at the power supply side is less that the first preset current, the method proceeds to S406. If the measured current at the power supply side of the first DC/DC conversion circuit is greater than or equal to the first preset current, the method proceeds to S407.

In step S406, it is confirmed that an arc fault occurs, and an alarm signal is generated and is outputted.

In step S407, it is determined that there is no arc fault, and the voltage at the power supply side of the first DC/DC conversion circuit is restored to the first voltage.

It can be seen from the above steps S401 to S407 that the voltage at the power supply side of the first DC/DC conversion circuit is decreased, and it is determined throughout whether the current at the power supply side is greater than the first preset current. If a false electric arc is detected, the current is once greater than the first preset current during the. If an arc fault actually occurs, the photovoltaic string connected to the first DC/DC conversion circuit fails to output current and the current at the power supply side does not exceed the first preset current. In this way, the real electric arc can be accurately distinguished from the false electric arc, thereby improving the accuracy of arc fault detection.

Various embodiments in this specification are described in a progressive manner. The same and similar parts between the embodiments may be referred to each other, and each of the embodiments focuses on differences from other embodiments. In particular, the system or embodiment of the system is similar to embodiments of the method, and therefore is described relatively simple, and may be referred to relevant parts of the embodiments of the method. The system and the embodiments of the system described above are only illustrative. Units described as a discrete component may or may not be physically separated. Components shown as units may or may not be physical units, that is, the components may be located in one place or may be distributed among multiple network units. Some or all modules thereof may be selected based on an actual requirement, to implement the solution in the embodiments. Those skilled in the art can understand and implement the present disclosure without any creative effort.

Those skilled in the art should further understand that, units and algorithm steps described in conjunction with the embodiments disclosed herein may be realized by electronic hardware, computer software or a combination thereof. In order to clearly illustrate interchangeability of the hardware and the software, the composition and steps of each of the embodiments are generally described above based on functions. Whether these functions are performed in hardware or software depends on the specific application and design constraints for the technical solution. Those skilled in the art may use different methods for each particular application to implement the described functions, but such implementation should not be considered as going beyond the scope of the present disclosure.

The description of the embodiments herein enables those skilled in the art to implement or use the present disclosure. Many modifications to these embodiments are apparent for those skilled in the art. The general principles defined herein may be applied to other embodiments without departing from the spirit or scope of the present disclosure. Therefore, the present disclosure should not be limited to the embodiments disclosed herein, but has the widest scope in accordance to the principle and the novel features disclosed herein.

## Claims

1. A method for detecting arcing, applied to an inverter, wherein the inverter comprises an inverter circuit and at least one DC/DC conversion circuit connected to a direct-current side of the inverter circuit, and the method comprises:
stopping outputting a control signal to a first DC/DC conversion circuit that is currently being suspected of having an electric arc, and operating other DC/DC conversion circuits connected to the inverter circuit normally;
decreasing a voltage at a power supply side of the first DC/DC conversion circuit immediately after a first preset period of time elapsed; and
determining that no arc fault occurs, and restoring the voltage at the power supply side of the first DC/DC conversion circuit to a first voltage that the first DC/DC conversion circuit receives before the stopping outputting the control signal, if a current at the power supply side is greater than or equal to a first preset current during the decreasing the voltage.

2. The method according to claim 1, wherein the decreasing the voltage at the power supply side of the first DC/DC conversion circuit immediately after the first preset period of time elapsed comprises:
decreasing the voltage at the power supply side of the first DC/DC conversion circuit to a target voltage immediately when the first preset period of time expires; and
proceeding to decrease the voltage at the power supply side of the first DC/DC conversion circuit, if the current at the power supply side is less than the first preset current throughout the decreasing the voltage to the target voltage.

3. The method according to claim 2, wherein
the target voltage is equal to the first voltage.

4. The method according to any one of claims 1 to 3, further comprising:
determining that an arc fault occurs, if the current at the power supply side is less than the first preset current throughout the decreasing the voltage.

5. The method according to any one of claims 1 to 3, wherein the current at the power supply side being less than the first preset current throughout the decreasing the voltage is determined by:
acquiring the current at the power supply side at the beginning of the decreasing the voltage;
decreasing the voltage at the power supply side of the first DC/DC conversion circuit by a first parameter and measuring the current at the power supply side subsequently, if the acquired current at the power supply side is less than the first preset current; and
proceeding to decrease the voltage at the power supply side of the first DC/DC conversion circuit by the first parameter and measure the current at the power supply side subsequently until the voltage at the power supply side of the first DC/DC conversion circuit is decreased to a voltage when the decreasing the voltage ends, if the previously measured current at the power supply side is less that the first preset current, wherein the finally measured current at the power supply side is less than the first preset current.

6. The method according to any one of claims 1 to 3, wherein the current at the power supply side being less than the first preset current throughout the decreasing the voltage is determined by:
acquiring the current at the power supply side at the beginning of the decreasing the voltage; and
decreasing the voltage at the power supply side of the first DC/DC conversion circuit to a voltage when the decreasing the voltage ends and measuring the current at the power supply side subsequently, if the acquired current at the power supply side is less than the first preset current, wherein the measured current at the power supply side is less than the first preset current.

7. The method according to any one of claims 1 to 3, wherein the current at the power supply side being greater than or equal to the first preset current is determined by:
determining that a minimum among absolute values of respective currents of all direct-current power supplies connected to the power supply side of the first DC/DC conversion circuit is greater than or equal to the first preset current; or
determining that absolute values of respective currents of all direct-current power supplies connected to the power supply side of the first DC/DC conversion circuit each are greater than or equal to the first preset current.

8. The method according to any one of claims 1 to 3, further comprising:
generating an alarm message and outputting the alarm message, when it is determined that an arc fault occurs.

9. An inverter, comprising:
a controller;
an inverter circuit, wherein an alternating-current side of the inverter circuit serves as an alternating-current side of the inverter and is configured to connect at least one of a power grid and an alternating-current load; and
at least one DC/DC conversion circuit, wherein a power supply side of the DC/DC conversion circuit serves as an interface at a direct-current side of the inverter and is configured to connect at least one direct-current power supply, and a bus side of the DC/DC conversion circuit is connected to a direct-current side of the inverter circuit through a direct-current bus, wherein
the controller is configured to control the inverter circuit and the DC/DC conversion circuit to perform the method according to any one of claims 1 to 8.

10. The inverter according to claim 9, wherein
the direct-current power supply is a photovoltaic string or a battery cluster.

11. A photovoltaic system, comprising:
a photovoltaic string; and
the inverter according to claim 9, wherein
the photovoltaic string is connected to an interface at the direct-current side of the inverter, and the alternating-current side of the inverter is configured to connect at least one of a power grid and an alternating-current load.
